# EUROPÄISCHE PATENTSCHRIFT

(11) **EP 3 174 669 B1**
(45) Veröffentlichungstag und Bekanntmachung des Hinweises auf die Patenterteilung: **14.04.2021**
(21) Anmeldenummer: 15742192.6
(22) Anmeldetag: 06.07.2015
(51) Int. Cl.: B25J 15/02, B25J 9/10, H01L 41/12

(54) **GREIFVORRICHTUNG SOWIE VERWENDUNG EINER GREIFVORRICHTUNG**
GRIPPER DEVICE, AND USE OF A GRIPPER DEVICE
DISPOSITIF DE PRÉHENSION ET UTILISATION D'UN DISPOSITIF DE PRÉHENSION

(30) Priorität: 01.08.2014 DE 102014110954
(43) Veröffentlichungstag der Anmeldung: 07.06.2017
(73) Patentinhaber: ETO MAGNETIC GMBH, 78333 Stockach (DE)
(72) Erfinder: SCHIEPP, Thomas, 78606 Seitingen-Oberflacht (DE); LAUFENBERG, Markus, 78333 Stockach (DE); RAAB, Markus, 91578 Leutershausen (DE); ERNST, Bernhard, 91575 Windsbach (DE)
(74) Vertreter: Patent- und Rechtsanwälte Behrmann Wagner PartG mbB
(86) Internationale Anmeldenummer: PCT/EP2015/065330
(87) Internationale Veröffentlichungsnummer: WO 2016/015953

(56) Entgegenhaltungen:
- WO-A1-2010/048765
- DE-A1-102012 224 367
- JP-A- H1 155 966
- JP-A- 2000 158 375
- RU-C1- 2 417 877

## Beschreibung

Die vorliegende Erfindung betrifft ein Greifsystem gemäß dem Oberbegriff des Anspruchs 1, mit einer entlang eines Bewegungspfades bewegbar ausgebildete Greifvorrichtung zum Fassen und Halten eines Werkstücks sowie zum Bewegen des Werkstücks entlang des Bewegungspfades, und mit Magnetfelderzeugungsmitteln. Ferner betrifft die vorliegende Erfindung eine Verwendung eines derartigen Greifsystems
Ein solches Greifsystem ist aus der DE 10 2012 224 367 A1 bekannt.

Aus den technischen Gebieten der Robotik, der Fabrikautomation und der Materialhandhabung sind gattungsgemäße Greifvorrichtungen allgemein bekannt. Mit dem Zweck, verschiedenste Werkstücke zu Bewegungszwecken an einer ersten Position an einem Bewegungspfad zu greifen und dann an eine davon verschiedene zweite Position des Bewegungspfades zu verbringen, sind gattungsgemäße Greifvorrichtungen als Arbeitsorgane typischerweise mittels zum Greifen ausgebildeter Arme oder Backen realisiert, welche als Reaktion auf einen (typischerweise pneumatischen oder elektromagnetischen) Antrieb in eine (etwa einen Kraft- und/oder Formschluss mit dem Werkstück bewirkende) Wirkpaarung mit dem Werkstück treten und sodann durch Bewegen der Greifvorrichtung auch das (mitnehmende) Bewegen des Werkstücks ermöglichen.

Je nach Bewegungs- bzw. Förderzweck, Art, Kontur oder Oberflächenausbildung des Werkstücks ist eines der bekannten Greifprinzipien von Vorteil, wobei, neben den Eigenschaften des Werkstücks, auch weitere Randbedingungen wie Zykluszeiten (für das Greifen bzw. die Transportbewegung), Zykluszahlen bzw. zu gewährleistende Standzeiten oder andere Umgebungsbedingungen (auch etwa Feuchtigkeits-, Kälte- oder Staubbelastungen) eine Rolle spielen.

Auch ist es als prinzipiell aus dem Stand der Technik bekannt vorauszusetzen, für gattungsgemäße Greifzwecke einen mittels eines magnetischen Formgedächtnislegierungsmaterials (auch bezeichnet als MSM=Magnetic Shape Memory) realisierte Aktorik einzusetzen; in ansonsten bekannter Weise wird zu diesem Zweck, insbesondere durch eine geeignet einen Aktorkristall umschließende Spule, ein als Reaktion auf das Bestromen der Spule expandierbarer Aktor zum Greifen des Werkstücks eingesetzt, wobei, etwa gegenüber pneumatischen oder elektromotorisch realisierten Greifersystemen, das MSM-Material Vorteile etwa in Reaktionszeit und Bewegungsgeschwindigkeit der Antriebsbewegung zeigt. Ein Beispiel für eine derartige Technologie zeigt die RU 24 17 877 C1.

Oft müssen die Aktormittel mit aufwändigen Peripherieeinheiten samt Zuleitungen versehen werden, so sind dies etwa die Fluid(druck)zuleitungen pneumatischer Systeme und die elektrischen Zuleitungen samt etwa der genannten Spulen bei elektromotorischen bzw. MSM-basierten Systemen. Derartige zusätzliche Leitungsinfrastruktur unterliegt allerdings gerade bei mit hohen Beschleunigungen, großen Bewegungstaktzahlen und/oder in belastenden Einsatzumgebungen eingesetzten Systemen hohen Verschleiß fördernden Belastungen, welche häufig eine wirksame Betriebsdauer entsprechend realisierter Systeme begrenzen bzw. Wartungs- und Überholungszyklen bestimmen, mit entsprechendem Zeit- und Kostenaufwand, was sich gerade in industriellen Förder-, Logistik- und Fertigungsumgebungen als verbesserungswürdig auswirkt.

Darüber hinaus bewirkt das Vorsehen der beschriebenen Zuleitungs- bzw. Antriebsinfrastruktur an bekannten Greifsystem, dass bewegte Komponenten, wie etwa die den ersten und den zweiten Kontaktabschnitt ausbildenden Arme bzw. Backen, zusätzlich mit bewegten Massen belastet sind, sodass das Dynamikverhalten der Greifvorrichtung beeinträchtigt ist. So werden etwa potentielle (Schalt)Geschwindigkeitsvorteile eines magnetischen MSM-Aktors zum Teil dadurch wiederum negativ kompensiert, dass im Rahmen des Gesamtsystems die für die Magnetfeldbeaufschlagung benötigten Spulenmittel am MSM-Kristall samt Zuleitungen die mechanische Trägheit des Gesamtsystems erhöhen. Entsprechendes gilt für elektromotorische bzw. pneumatische Aktormittel, deren Bewegbarkeit (bzw. Beschleunigbarkeit) gleichermaßen durch die diskutierte Zuleitungsinfrastruktur beeinträchtigt bzw. begrenzt wird.

Aufgabe der vorliegenden Erfindung ist es daher, ein Greifsystem zu schaffen, welches sowohl im Hinblick auf eine konstruktive Einfachheit der bewegbar ausgebildeten Greifvorrichtung, als auch eine Dynamik einer Greifvorrichtung, insbesondere durch Verringerung einer bewegten Masse und Verringerung des Einflusses einer Zuleitungsinfrastruktur für die Aktormittel, verbessert ist. Dabei soll insbesondere eine bewegbar ausgebildete Greifvorrichtung geschaffen werden, welche sich für industrielle Förder- und Transportzwecke von Werkstücken eignet, die im Hinblick auf erreichbare Werkstückgeschwindigkeiten und -beschleunigungen, insbesondere bei Reduzierung von Takt- und Zykluszeiten, verbessert ist, gleichzeitig geringeren Verschleiß und damit höhere Standzeiten zeigt und generell das Errichten eines betriebssicheren, wartungsarmen und konstruktiv einfach zu realisierenden Greifsystems ermöglicht.

Die Aufgabe wird durch das Greifsystem mit den Merkmalen des Hauptanspruchs gelöst. Vorteilhafte Weiterbildungen der Erfindung sind in den Unteransprüchen beschrieben. Unabhängiger Schutz im Rahmen der Erfindung wird zudem beansprucht für eine Verwendung eines derartigen Greifsystems, welche vorteilhaft für Zwecke der industriellen Fertigungsund Fördertechnik ist.

In erfindungsgemäß vorteilhafter Weise wirken die die Antriebskraft auf den ersten Kontaktabschnitt bringenden und damit diesen für die Wirkpaarung antreibenden Aktormittel aus dem magnetischen Formgedächtnislegierungsmaterial mit Magnetfelderzeugungsmitteln zusammen, welche von der Greifvorrichtung ausgelagert sind, also nicht mechanisch mit einem die Kontaktabschnitte an geeigneten Backen oder Armen ausbildenden Greiferkörper mechanisch verbunden sind, sondern separat von diesem Greiferkörper und bevorzugt stationär vorgesehen sind. Damit ist nicht ausgeschlossen, dass die Greifvorrichtung selbst, etwa am Greiferkörper, auch (zusätzliche) Magnetfelderzeugungsmittel aufweisen kann. Der wesentliche Vorteil der Erfindung, und insoweit als bevorzugte Ausführungsform zu realisieren, besteht jedoch darin, dass die zum Bewirken der Magnetfeldbeaufschlagung der (greiferseitigen) Aktormittel erfindungsgemäß vorgesehenen Magnetfelderzeugungsmittel getrennt von einem Greiferkörper und, wiederum bevorzugt, an einer festen, einer Position am Bewegungspfad zugeordneten Stelle vorgesehen sind, an welcher dann das Zusammenwirken ermöglicht ist. Mit anderen Worten, diese erfinderische Maßnahme der stationären, ausgelagerten Magnetfelderzeugungsmittel gestattet das magnetische Zusammenwirken für die Magnetfeldbeaufschlagung der Aktormittel dann, wenn sich die Greifvorrichtung an oder benachbart der Position befindet, an welcher die Magnetfelderzeugungsmittel ausgebildet und vorgesehen sind, sodass an dieser Position dann in ansonsten bekannter Weise eine Magnetfeld-induzierte Expansion oder Kompression des magnetischen Formgedächtnislegierungsmaterials mit dem Zweck des Herstellens (oder Lösens) der Wirkpaarung zum Werkstück stattfinden kann. Allerdings findet, durch das erfindungsgemäße stationäre (bzw. mechanisch unabhängig ggf. auch anderweitig bewegbar) ausgestaltete Vorsehen der Magnetfelderzeugungsmittel bezogen auf die Greifvorrichtung und die Aktormittel das magnetische Zusammenwirken nur an der entsprechenden Position der Magnetfeldmittel statt. An weiteren Positionen entlang des Bewegungspfades findet keine derartige magnetische Interaktion statt, diese ist jedoch insbesondere dann auch nicht notwendig, wenn durch das magnetische Zusammenwirken an der stationären Position der Magnetfelderzeugungsmittel das gewünschte Greifen bzw. Lösen des Werkstücks realisiert wird und dann die weiteren Bewegungsvorgänge (und Positionen) entlang des Bewegungspfades lediglich ein Halten des Werkstücks an der Greifvorrichtung gestatten müssen, wobei jedoch im Rahmen der Erfindung keine Magnetfeldbeaufschlagung notwendig ist. Eine weiterbildungsgemäß vorgesehene weitere (zweite) Position des Bewegungspfades mit (zusätzlichen) Magnetfelderzeugungsmitteln würde dann etwa als Zielposition ein (erneutes) magnetisches Zusammenwirken mit den Aktormitteln gestatten, um etwa dann ein (zuvor aufgenommenes) Werkstück zu lösen bzw. abzugeben.

Der offensichtliche Vorteil dieser erfindungsgemäßen Maßnahme liegt zunächst darin, dass die Magnetfelderzeugungsmittel zum magnetischen Zusammenwirken mit den Aktormitteln bzw. für deren Magnetfeldbeaufschlagung nicht (da nicht mehr bewegte Teile der Greifvorrichtung) zur bewegten Masse beitragen, nicht selbst beschleunigt werden müssen und so die mechanischen Dynamikeigenschaften der Vorrichtung signifikant verbessern. Darüber hinaus wird die Struktur eines die Greifvorrichtung realisierenden Greifkörpers signifikant vereinfacht, denn dieser muss in der einfachsten Form lediglich die Kontaktabschnitte realisieren und die auf den ersten Kontaktabschnitt mit der Antriebskraft wirkenden Aktormittel geeignet aufnehmen bzw. verankern, dagegen sind etwa elektromagnetische Spulenmittel samt elektrischen Zuleitungen, ergänzend oder alternativ auch (potentiell gewichtsträchtige und spröde, daher aufprallgefährdete) Permanentmagnetmittel als typische Magnetfelderzeugungsmittel stationär und damit unbeweglich vorgesehen, unterliegen entsprechend keinen signifikanten Verschleißerscheinungen mehr und beeinträchtigen nicht, wie dargelegt, die dynamischen Eigenschaften des Systems.

Im Rahmen von Realisierungsmöglichkeiten der Erfindung ist dabei die erfindungsgemäße Wirkpaarung breit und umfassend zu verstehen; darunter gefasst werden soll sowohl ein Klemmen, Reiben oder dergleichen seitliches Angreifen des ersten bzw. zweiten Kontaktabschnitts an eine geeignete (Außen-)Fläche des (nahezu beliebig ausgestaltbaren) Werkstücks, als auch ein (einen Formschluss ermöglichendes) Mitnehmen, Eingreifen oder Verriegeln in geeignete Nuten, Hinterschneidungen, Vorsprünge oder dergleichen Angriffsabschnitte des Werkstücks, wobei dann entsprechend einer gewünschten Wirkung beim Fassen oder Halten der erste bzw. zweite Kontaktabschnitt entsprechend konturiert oder ausgestaltet sein kann.

Während es zudem im Rahmen einer bevorzugten Weiterbildung der Erfindung liegt, die Kontaktabschnitte mittels eines zangenartig wirkenden Greifers zu realisieren und hier weiter bevorzugt Greifbacken und/oder Greifarme zum Fassen bzw. Halten des Werkstücks vorzusehen, ist auch diese Ausgestaltung zwar bevorzugt, aber nicht beschränkend zu verstehen. Allerdings ist, in weiterer bevorzugter Ausgestaltung, mit einem flachen, etwa metallischen und/oder aus einem Kunststoffmaterial gebildeten Greiferkörper in besonders geeigneter Weise eine Realisierung der Erfindung ermöglicht, welche einfache Herstellbarkeit und eine hohe Dauerbelastbarkeit mit Störungsunempfindlichkeit und geringen Herstellungskosten verbindet. Dabei ist sowohl eine einstückige Ausgestaltung denkbar (etwa in der Art eines durch Spritzgießen vom Kunststoffmaterial realisierten Bügels mit Armen zum Ausbilden der Kontaktabschnitte, wobei dann ein MSM-Körper als Aktormittel geeignet zwischen den elastisch bewegbaren Armen platziert ist), alternativ wäre auch eine Ausbildung mit einem oder mehreren Scharnier- bzw. Gelenkabschnitten zwischen Komponenten eines mehrteiligen Greiferkörpers denkbar, wobei diese Abschnitte dann wiederum an geeigneter Stelle und zum Herstellen und Aufbringen der Antriebskraft die die Kontaktabschnitte realisierenden Mechanikkomponenten verbinden. Je nach einzusetzendem Material für die Realisierung des Greiferkörpers und dessen Eignung für eine Deformation (etwa im Fall eines einstückig zu realisierenden Greifers) oder eine Mehrteiligkeit wird der Fachmann entsprechend einem jeweiligen Handhabungszweck die geeignete Ausbildung und Konfiguration wählen, wobei auch eine Realisierung der erfindungsgemäßen Aktormittel mittels eines langgestreckten (Einfach- oder Mehrfach-)Körpers zur Magnetfeld induzierten Expansion oder Kontraktion in der Erstreckungsrichtung eine bevorzugte Variante in der Realisierung ist, die Erfindung jedoch auch nicht auf derartige Ausführungsformen beschränkt ist.

In der praktischen Realisierung der Erfindung und weiterbildungsgemäß hat es sich als bevorzugt herausgestellt, insbesondere am oder im Greifer den Aktormitteln Rückstell- und/oder Federmittel zuzuordnen, welche sich mit ihrem Kraftverhalten einer Kraft der Aktormittel überlagern; im einfachsten Fall kann etwa eine Feder mechanisch parallel zu einem MSM-Körper zwischen die Kontaktabschnitte realisierenden Armen bzw. Backen der Greifvorrichtung gespannt sein. Diese Federmittel können dann geeignet dimensioniert bzw. eingerichtet sein, das Halten des Werkstücks auch nach einem Ende der Magnetfeldbeaufschlagung der Aktormittel (also etwa nach einem elektrischen Deaktivieren eines Elektromagneten oder nach einem räumlichen Bewegen der Greifvorrichtung aus einem magnetisch wirksamen Eingriff mit den stationär vorgesehenen Magnetfelderzeugungsmitteln) zu ermöglichen: Wird nämlich, etwa nach Magnetfeld-induzierter Expansion eines Körpers, die Magnetfeldbeaufschlagung beendet, verbleibt zwar der Körper in der expandierten Stellung, eine (fortgesetzte) Kraftbeaufschlagung eines an einem angetriebenen Kontaktabschnitt sitzenden Werkstücks ist jedoch im Regelfall nicht mehr möglich. Hier würde dann etwa eine geeignet vorher eingebrachte (permanente) Federkraft einer Zug- oder Druckfeder wirken und insoweit das erfindungsgemäße Halten des Werkstücks im Rahmen des Systems unterstützen.

In der konkreten, weiterbildungsgemäßen Ausgestaltung dieser Rückstell- bzw. Federmittel (wobei anstelle einer - mechanischen - Feder etwa auch geeignet mit einem Magnetfeld beaufschlagbare, z.B. entgegengesetzt gerichtete Formgedächtnislegierungsmaterialien eingesetzt werden könnten) ist es einerseits weiterbildend vorgesehen und vorteilhaft, Rückstell- bzw. Federkräfte dieser Rückstell- bzw. Federmittel so einzurichten, dass diese eine Kompression (Rückstellung) eines durch Magnetfeldwirkung expandierten MSM-Körper im nicht-feldbeaufschlagten Zustand ermöglichen. Damit muss dann zwar die Magnetfeldbeaufschlagung bei einer Expansion der Aktormittel stets diese rückstellende (Feder) überwinden, vorteilhaft kann jedoch eine MSM-Körperanordnung umgesetzt werden, bei welcher lediglich eindimensional und senkrecht zu einer Expansionsrichtung (damit typischerweise einer Längs- bzw. Erstreckungsrichtung eines langgestreckt ausgebildeten Aktorkristalls) eine Magnetfeldbeaufschlagung erfolgt. Da bei der Auslegung und Konzeption neben den Federeigenschaften auch die magnetomechanischen Eigenschaften des MSM-Körpers relevant sind, würde bei dieser Variante die sogenannte Zwillings-Spannung (auch Twinning-Stress genannt), also die ohne Magnetfeld erforderliche mechanische Kraft zur Rückstellung, geeignet durch Materialwahl ausgestaltet und an die Federkraft angepasst werden. Entsprechendes gilt für eine alternative Vorgehensweise bei der Implementierung zugeordneter Rückstell- bzw. Federmittel zu den Aktormitteln. Werden diese so eingerichtet, dass der damit versehene Greifer nach der Magnetfeldbeaufschlagung in seiner aktivierten Position verbleibt (und nicht durch die Rückstell- bzw. Federmittel zurückgestellt wird, etwa weil diese, gegenüber der Zwillingsspannung, eine schwächere Federkraft aufweisen) ergibt es mit einer entsprechend hoch konzipierten bzw. eingerichteten Zwillingsspannung eine potentiell hohe Greifkraft auf oder an das Werkstück. Ein Rückstellen (bzw. Schließen) dieser Konfiguration würde dann bevorzugt durch das Anlegen eines Magnetfelds in einer gegenüber der ersten Magnetfeldrichtung orthogonalen Magnetfeldbeaufschlagung erfolgen, was durch geeignete Ausgestaltung bzw. Positionierung von Magnetfelderzeugungsmitteln, etwa an einer zweiten, ein Lösen bzw. Ablegen ermöglichenden Position entlang des Bewegungspfades, vorgesehen sein kann. Der Vorteil dieser Variante ist, dass eine damit realisierte Greifvorrichtung nicht erst aus einer (insoweit monostabilen) Ausgangsposition geöffnet bzw. bewegt werden muss, was wiederum potentielle Geschwindigkeitsvorteile realisieren kann. Allerdings ist eine Greifkraft, da im Wesentlichen durch die Zwillingsspannung des Materials bestimmt, potentiell geringer, als bei der zuerst diskutierten Variante.

In allen Fällen wird eine vorteilhafte Realisierung der Aktormittel durch einen oder mehrere MSM-Körper erfolgen, welche als in der Regel einkristallines Material auf der Basis von NiMnGa (gegebenenfalls mit weiteren Dotierungen) hergestellt und als solche auch für Aktorzwecke als allgemein bekannt vorauszusetzen sind.

Das im Rahmen der Erfindung für die Magnetfeldbeaufschlagung der Aktormittel zu verwendende Magnetfeld kann erfindungsgemäß weiterbildend permanentmagnetisch oder elektromagnetisch (oder durch eine Kombination dieser Verfahren) erzeugt werden, wobei sowohl etwaige Permamentmagnete, als auch Kern- und Spulenmittel einer elektromagnetischen Variante erfindungsgemäß getrennt und ausgelagert von der Greifvorrichtung und bevorzugt stationär und an mindestens einer festen, unbeweglichen Position entlang des Bewegungspfades, entsprechend einem jeweiligen Zweck des Einwirkens auf die Aktormittel an dieser Position, vorgesehen sein können.

Insbesondere beim Einsatz von elektromagnetischen Magnetfelderzeugungsmitteln lässt sich zudem die Effizienz des Systems darin erkennen, dass eine (insoweit elektrische Leistung verbrauchende) Aktivierung von Spulenmitteln derartiger Elektromagneten nur erfolgen muss, wenn zum Zweck der Magnetfeldbeaufschlagung beim magnetischen Zusammenwirken mit den Aktormitteln ein Magnetfeld gebraucht wird; es wird deutlich, dass bei sämtlichen Bewegungs- und Förderschritten entlang des Bewegungspfades außerhalb der Station(en) zum Greifen bzw. Lösen ein energieloses Halten des Werkstücks erfolgt.

Im Ergebnis gestattet damit die vorliegende Erfindung in überraschend einfacher und eleganter Weise das Weiterentwickeln bekannter (mittels MSM-Aktormitteln zu realisierender) Greif-, Transport- und Fördersysteme, wobei jedoch die erfindungsgemäße Auslagerung (Verlagerung) der Magnetfeldbeaufschlagung für die Aktormittel hin zu einer stationären Position, losgelöst von der eigentlichen, bewegten Greifervorrichtung, signifikante Vorteile sowohl im Hinblick auf eine Beweg- und Beschleunigbarkeit dieser Greifervorrichtung erreicht, als auch die Gefahr von Verschleiß, Störungen und anderen Fehlfunktionen deutlich vermindert.

Weitere Vorteile, Merkmale und Einzelheiten der Erfindung ergeben sich aus der nachfolgenden Beschreibung bevorzugter Ausführungsbeispiele sowie anhand der Figuren; diese zeigen in:
- Fig. 1: eine prinzipielle Schemaansicht einer Greifvorrichtung gemäß einem ersten Ausführungsbeispiel der Erfindung im Greifzustand (Teilfigur (a)) sowie im geöffneten Zustand (b);
- Fig. 2: Schemaansichten in analogen Teilfiguren eines zweiten Ausführungsbeispiels der Greifvorrichtung;
- Fig. 3: in Abfolge der Teilfiguren (a) bis (c) Ansichten eines mit der Greifvorrichtung des Ausführungsbeispiels der Fig. 2 realisierten Greifsystems in verschiedenen Bewegungs- und Transportstufen;
- Fig. 4: in Teilfiguren (a) bis (e) schematische Längsschnittansichten zum Verdeutlichen einer Betriebsweise einer weiteren Ausführungsform der Erfindung mit elektromagnetischer Magnetfeldbeaufschlagung sowie in Teilfiguren (f) und (g) mit permanentmagnetischer Magnetfeldbeaufschlagung;
- Fig. 5: eine Prinzipdarstellung eines weiteren Ausführungsbeispiels mit einem drei Aktoren aufweisenden Greifer und
- Fig. 6: ein weiteres Ausführungsbeispiel der Erfindung mit zwei ein Öffnen bzw. Schließen des gezeigten Greifers ermöglichenden MSM-Aktorbaugruppen.

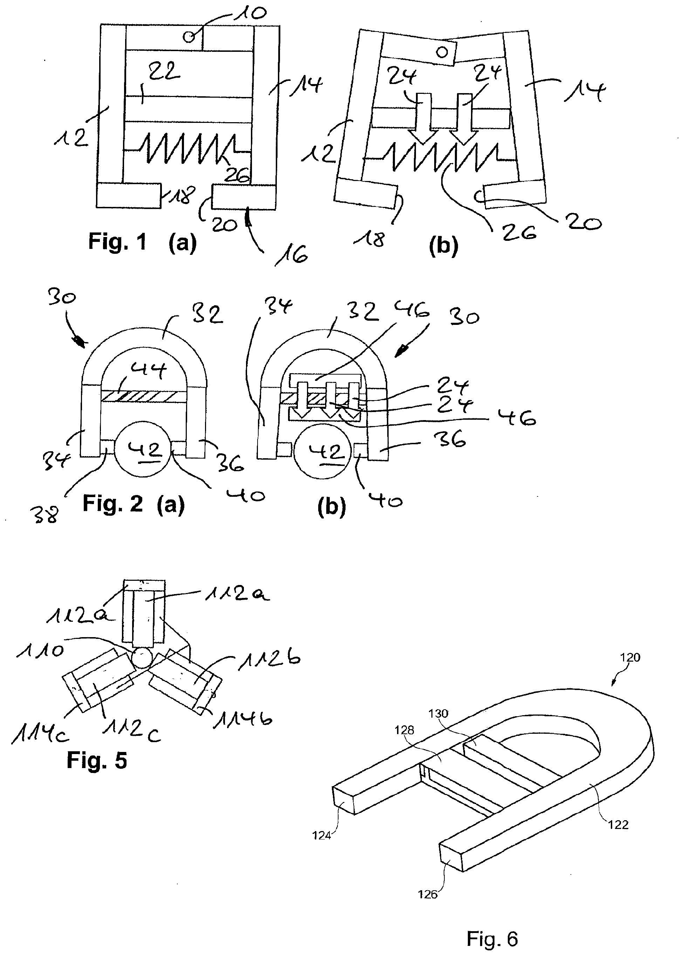

Anhand der Fig. 1 und 2 werden mögliche prinzipielle Ausgestaltungen der vorliegenden Erfindung (nicht abschließend im Hinblick auf die Variantenbreite) erläutert. So weist eine im ersten Ausführungsbeispiel der Fig. 1 schematisch gezeigte Greifvorrichtung einen aus zwei zueinander um ein Gelenk 10 schwenkbar verbundenen Greifarmen 12, 14 gebildeten Greifer 16 auf, der mittels eines Paares von an freien Enden der Arme 12, 14 ausgebildeten Backenabschnitten 18 bzw. 20 Kontaktabschnitte zum Zusammenwirken mit einem (in der Fig. 1 nicht gezeigten) Werkstück aufweist.

Ein in der gezeigten Weise langgestreckt ausgebildeter MSM-Kristallkörper 22 aus einer ein magnetisches Formgedächtnisverhalten zeigenden NiMnGa-Legierung verbindet die Arme 12, 14 so, dass eine durch Eintragen eines quer zur Erstreckungsrichtung des Aktorelements 22 eingetragenes Magnetfeld (Pfeile 44 in Fig. 1 (b)) eine Expansion des MSM-Kristalls entlang der Erstreckungsrichtung bewirkt. In der gezeigten Weise spreizt diese Längenveränderung das Paar der Arme 12, 14 auf, so dass in Teilfigur 1 (b) der Greifer zum Aufnehmen eines Werkstücks an den Backen bzw. den dort gebildeten Kontaktabschnitten 18, 20 geöffnet ist. Wie die Fig. 1 zudem erkennen lässt, erfolgt die Expansion des Kristallkörpers 22 gegen eine Rückstellkraft einer (schematisch gezeigten) und mechanisch parallel zum MSM-Kristallkörper 22 mit den Armen 12, 14 verbundenen Zugfeder 26, welche im Hinblick auf ihr Kraftverhalten so eingerichtet ist, dass bei Beendigung der schematisch mit den Pfeilen 24 in Fig. 1 (b) gezeigten magnetischen Durchflutung ein Zurückführen des MSM-Aktors 22 in seine kontrahierte Ausgangsposition (Fig. 1 (a)) erfolgt. Zusätzlich wird durch die Feder 26 erreicht, dass bei zwischen den Backen 18, 20 etwa in der aufgespreitzten Stellung der Fig. 1 (b) gehaltenem Werkstück als Transportgut die Feder für eine Andruck- und Haltekraft sorgt, selbst wenn, bei beendeter magnetischer Durchflutung 24, durch das MSM-Material selbst keine Krafterzeugung mehr erfolgt.

Ein zweites Ausführungsbeispiel zum Realisieren der Greifvorrichtung im Rahmen der vorliegenden Erfindung verdeutlicht die Fig. 2 wiederum mit den Teilfiguren (a) und (b). Hier ist zunächst ein Greiferkörper 30 einstückig aus einem Kunststoffmaterial mit einem Bügel- bzw. Bogenabschnitt 32 und ansitzenden Armabschnitten 34, 36 ausgebildet; im Bereich der freien Enden der Armabschnitte 34, 36 bilden wiederum Backenabschnitte 38, 40 als Kontaktabschnitte zum Zusammenwirken mit einem (hier zylindrischen, in der Draufsicht gezeigten) Werkstück 42 aus. Ein langgestreckt ausgebildeter MSM-Kristallkörper 44 als Aktormittel ist so ausgestaltet, dass als Reaktion auf eine magnetische Durchflutung (orthogonal zur Längsrichtung, wiederum verdeutlicht durch Pfeile 24 in Teilfigur (b)) eine Expansion in einer Längs- bzw. Erstreckungsrichtung erfolgt; Teilfigur 2 (b) verdeutlicht eine als Reaktion auf die Magnetfeldbeaufschlagung und damit Expansion des Körpers 44 erreichte Aufweitung des zangenartigen Greifkörpers 30, mit dem Ergebnis, dass die Backenabschnitte 38, 40 sich vom Werkstück 42 lösen und dieses entsprechend freigeben.

Wichtig ist, dass schematisch zum Erzeugen des Magnetfeldes 24 gezeigte Magnetfelderzeugungsmittel 46 (Fig. 2 (b), wobei diese analog etwa auch bei Fig. 1 (b) den Magnetfluss 24 durch die Aktorbaugruppe 22 erzeugen würden) nicht Teil der in Fig. 1 bzw. Fig. 2 gezeigten Greifvorrichtung sind bzw. in keiner Weise mechanisch mit den Greifern 16 oder 30 verbunden sind, damit auch nicht mit diesen bewegbar sind oder bewegt werden.

Vielmehr verdeutlicht die nachfolgend als weitere Ausführungsform und im Rahmen eines mit der erfindungsgemäßen Greifvorrichtung ausgebildeten Greifsystems gezeigte Darstellung samt Abfolge von Bewegungsschritten entlang des Bewegungspfades die erfindungsgemäße Funktionalität der ausgelagerten Magnetfeldbeaufschlagung, nämlich durch hier stationär vorgesehene Magnetfelderzeugungsmittel.

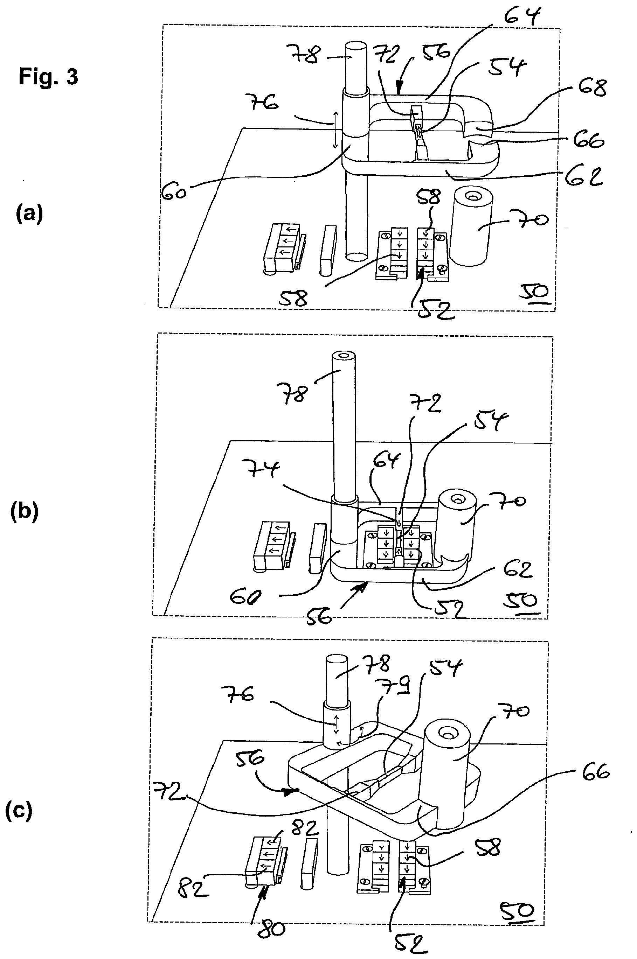

Konkret verdeutlicht die Fig. 3, wie auf einer Trägerplatte 50 Magnetfelderzeugungsmittel 52 in Form von einer beidseits zum Zusammenwirken mit einem langgestreckten magnetischen MSM-Körper 54 als Aktormittel ausgebildeten Permanentmagneten 52 stationär befestigt sind, damit unabhängig von der in Fig. 3 bewegbar gezeigten Greifvorrichtung 56 ortsunveränderlich montiert sind. Die Permanentmagneten 52 sind so ausgestaltet, dass diese entlang einer symbolisch gezeigten Pfeilschar 58 ein (permanentmagnetisches) Magnetfeld im MSM-Kristallkörper 54 eintragen können, wenn sich dieser, im Teilbild der Fig. 3 (b), benachbart und damit im unmittelbaren magnetisch wirksamen Eingriff mit den Permanentmagneten 52 befindet.

Der Greifer 56 ist im gezeigten Ausführungsbeispiel der Fig. 3 als (mit eingelegtem Kristallkörper 54) einstückig ausgebildetes Bügel- bzw. Rahmenelement ausgestaltet, wobei gelenkartig an einem Bügelabschnitt 60 miteinander verbundene Arme 62, 64 an ihren jeweiligen freien Enden einen ersten Kontaktabschnitt 66 und einen zweiten Kontaktabschnitt 68 ausbilden, welcher zum Greifen bzw. Halten eines hier als zylindrischer Körper ausgebildeten Werkstücks 70 als Transportgut ausgeformt sind. Der über Stegabschnitte 72 an den Armen 62, 64 befestigte Kristallkörper 54 als Aktor ist so ausgewählt und ausgestaltet, dass als Reaktion auf eine Magnetfeldbeaufschlagung eine Kontraktion, also eine Längenverkürzung entlang der Erstreckungsrichtung des Kristalls, erfolgt, wie die zugehörigen Pfeile 74 in Teilfigur (b) verdeutlichen. Entsprechend führt diese Kontraktion zu einem Schließen des zangenartigen Greifers, mit der Wirkung, dass die Kontaktabschnitte 66, 68 zum Greifen und Halten des Transportguts 70 aufeinander zu bewegt werden und in einer kontrahierten Betriebsstellung des Kristalls 54, bedingt durch die ZwillingsSpannung im Kristall, das Werkstück 70 halten.

Im gezeigten Ausführungsbeispiel ist der Greifer 54 sowohl entlang von Pfeilrichtungen 76 auf- und abwärts bewegbar gelagert, als auch um die zugehörige Führungsachse 78 horizontal, d.h. parallel zur Ebene der Grundplatte 50, verschwenkbar.

Einen entsprechenden Bewegungsbetrieb verdeutlicht die Abfolge der Teilfiguren (a) bis (c) von Fig. 3: In der gemäß (a) aufgeweitet gezeigten Weise fährt der Greifer 56 entlang der Führung 78 abwärts und umschließt zunächst mantelseitig, wie in Teilfigur (b) zu erkennen, das zu greifende und daraufhin dann zu transportierende bzw. zu bewegende Werkstück 70. Bei der Abwärtsbewegung des Greifers 56 in Richtung auf den unterliegenden planen Träger 50 gerät der Aktor 54 zwischen das Paar von stationär und fest am Boden 50 befestigten Permanentmagnetstreifen 52, so dass ein Permanentmagnetfeld dieser Magnetfelderzeugungsmittel im Betriebszustand der Teilfigur (b) so magnetisch mit dem Kristall 54 zusammenwirkt, dass die durch Pfeile 74 schematisch illustrierte Kontraktion stattfindet. Die entsprechend dieser Antriebskraft aufeinander zu bewegten Arme 52, 54 greifen mit ihren endseitig vorgesehenen und auf das Werkstück gerichteten Kontaktabschnitten 66, 68 auf die Mantelfläche des Werkstücks 70 und erzeugen dort eine Haft- bzw. Haltekraft. Ein nachfolgendes Wieder-Anheben der Greifervorrichtung 56 in Aufwärtsrichtung des Pfeils 76, verbunden mit einem Verschwenken entlang Pfeilrichtung 78 bewirkt dann das Mitnehmen des zwischen den Backen-Endabschnitten 66, 68 gehaltenen Werkstücks 70, und entsprechend dem vorgesehenen Bewegungs- und Transportzweck kann dann an einer vorgesehenen Löse- bzw. Ablageposition das Werkstück 70 platziert werden. Im Ausführungsbeispiel der Fig. 3 sind hierfür die im linken Bereich auf dem Träger 50 gezeigten, stationären zusätzlichen Magnetfelderzeugungsmittel 80 in Form einer weiteren Permanentmagnetanordnung vorgesehen. Konkret würde dann im weiteren Verlauf der Schwenkbewegung entlang Pfeilrichtung 78 und einem nachfolgenden (erneuten) Absenken des Greifers 56 in Richtung auf die Trägerplatte 50 der Kristall 54 in Eingriff mit den weiteren Permanentmagneten treten. Diese weisen, symbolisiert durch die Pfeilschar 82, eine Magnetisierung dergestalt auf, dass, im Gegensatz zur durch die Permanentmagneten 52 bewirkten Längsdurchflutung des Kristalls, eine Querdurchflutung stattfindet, welche im gezeigten Ausführungsbeispiel eine Expansion des MSM-Kristallmaterials und mithin ein Auseinandertreiben der Arme 62 ,64 samt endseitigen Kontaktabschnitten 66, 68 bewirkt. Diese Lösen sich dann von der Bewegungslast 70, so dass diese dann in vorgesehener Weise abgelegt werden würde.

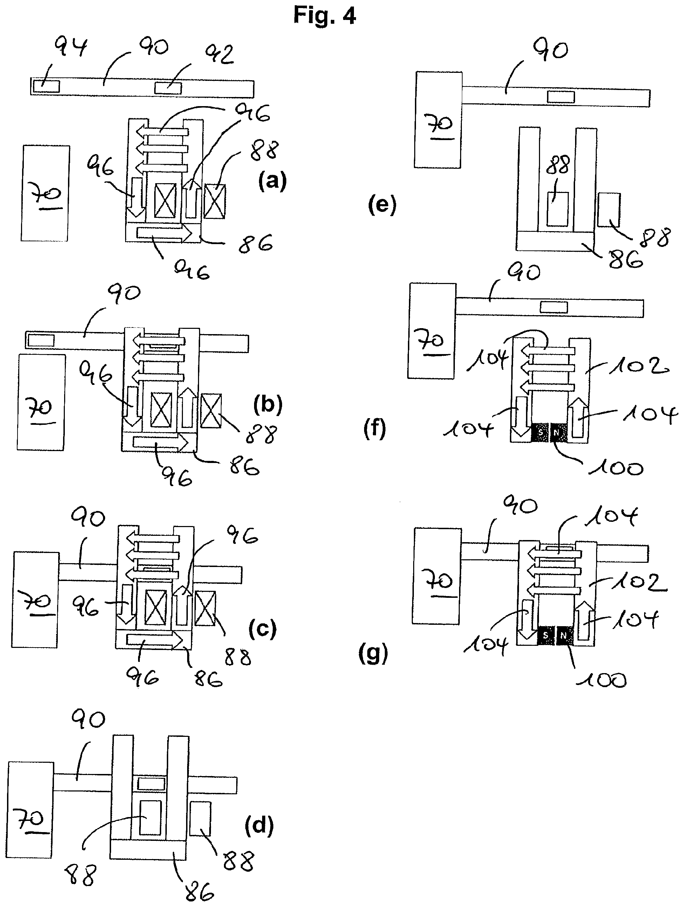

In den Schemadarstellungen der Fig. 4 werden diese Vorgänge im Hinblick auf die magnetischen Flussverhältnisse ergänzend illustriert, wobei die Teilfiguren (a) bis (e) der Fig. 4, als Alternative zur Ausbildung der Magnetfelderzeugungsmittel 52 in Fig. 3 als Permanentmagneten, in Fig. 4 eine Elektromagnetvorrichtung zeigen, welche eine in der Längsschnittansicht bügelförmig gezeigte Kernstruktur 86 ausbildet, welche durch geeigneten Steuerstrom bestrombare Spulenmittel 88 magnetfelderzeugend zugeordnet aufweisen. Das Bezugszeichen 90 in Fig. 4 verdeutlicht eine Greifeinheit, etwa analog der Fig. 1, 2 oder 3 ausgebildet, mit schematisch in Seitenansicht gezeigtem MSM-Kristallkörper 92 (sich insoweit dann langgestreckt senkrecht zur Figurenebene der Fig. 4 erstreckend) und mit Kontaktabschnitten 94 zum geeigneten haltenden Zusammenwirken mit dem (z.B. wiederum zylindrisch ausgestalteten) Werkstück 70 als Greif- bzw. Transportgut.

Die Funktionalität der in Fig. 4(a) bis (e) dargestellten Technologie ist wie folgt: Bei sich (in der Figurenebene abwärts) auf die stationären Magnetfelderzeugungsmittel 86, 88 zu bewegendem Greifer 90 wird die Spule 88 bestromt, so dass entsprechend der Pfeilschar 96 ein elektromagnetisches Feld erzeugt wird. Sobald, wie in Teilfigur (b) verdeutlicht, der Greifer 90 obere Schenkel 98 des Elektromagnetkerns 98 erreicht, durchflutet das elektromagnetisch erzeugte Feld 96 den MSM-Körper, und der (gabel- bzw. zangenartig wirkenden) Greifer 90 schließt sich, wobei die schematisch gezeigten Kontaktabschnitte 94 in Richtung auf den Mantel des Werkstücks 70 zum Greifen desselben bewegt werden.

Teilfigur (c) von Fig. 4 verdeutlicht diesen Betriebszustand; bei noch aktiviertem elektromagnetischem Feld 96 der Spule 88 erreicht der Greifer 90 seine tiefste Position; am endseitigen Kontaktbereich 94 des Greifers erfolgt bereits das Halten des Körpers 70.

Vor einem erneuten Anheben des Greifers 90 und Mitnehmen des Werkstücks 70 erfolgt, wie in Teilfigur (d) gezeigt, durch Deaktivieren des Spulenstroms durch die Spuleneinheit 88 ein Deaktivieren der Magnetfeldbeaufschlagung 96. Durch die Twinning-Spannung des Kristallkörpers 92 verbleiben gleichwohl Kontaktabschnitte 94 zum Halten am Körper 70, so dass dieser - bei fortgesetzt deaktivierter Magnetfeldbeaufschlagung - in Teilfigur (e) entlang des Bewegungspfades angehoben und zum weiteren Transport mitgenommen werden kann.

Die Teilfiguren (f) und (g) verdeutlichen in Form einer schematisch gezeigten Permanentmagnetanordnung 100 mit einen Permanentmagnetfluss 104 führenden Kernabschnitten 102, wie die Magnetfelderzeugungsmittel alternativ ausgestaltet werden können; insoweit das Ausführungsbeispiel der Teilfiguren (a) bis (e) weiterbildend, können die permanentmagnetischen Magnetfelderzeugungsmittel insoweit auch an einer zweiten (hier etwa zum Lösen der Last 70 vom Greifer 90 zu verwendenden) Position angeordnet sein, wobei, im Figurenübergang von den Teilfiguren (f) zu (g) die Durchflutung 104 im Zusammenwirken mit dem Kristall 92 so ausgebildet sein kann, dass etwa dann im Betriebszustand (g) durch Expansion des Kristallkörpers 92 der Haltezustand aufgehoben und insoweit das Werkstück 70 gelöst bzw. freigegeben werden kann.

Die vorliegende Erfindung ist weder auf die beschriebenen bügel- bzw. zangenartig ausgebildeten und wirkenden Greifvorrichtung bzw. Greifprinzipien beschränkt, vielmehr sind diese lediglich exemplarisch zu verstehen und wären je nach konkretem Einsatzfall geeignet auszugestalten.

So verdeutlicht etwa die Fig. 5 ein weiteres Ausführungsbeispiel der Erfindung als Mehrfachgreifer, bei welchem zentral von einem Widerlager 110 abgestützt, ein Greifer mit drei Aktorbaugruppen in Form jeweils langgestreckter MSM-Kristallstäbe 112a, 112b und 112c als Reaktion auf eine (jeweilige) Magnetfeldbeauschlagung mit endseitigen Kontaktabschnitten 114a bis 114c in Eingriff mit einem (z.B. an einem lichten Innenmantel zu fassenden) Werkstück angreifen können. Auch hier steht es im Belieben der notwendigen Ausgestaltung, geeignete Mittel für die Magnetfelderzeugung auszuwählen und ggf. eine Rücksetzung bzw. Rückstellung (in Form geeignet vorzusehender Federn) auszubilden.

Wiederum eine weitere Variante der Erfindung ist schematisch mit dem Greifer 120 der Fig. 6 gezeigt. Der bügelartig etwa aus einem Kunststoffmaterial gebildete Körper 122 ist mit freien Endabschnitten 124, 126, etwa in vorstehend beschriebener Weise, geeignet zum Greifen eines Werkstücks ausgestalt- bzw. konfigurierbar. Einem zum Auseinanderdrücken bzw. Zusammenführen der Arme eingesetzten MSM-Kristallkörper 128 ist im gezeigten Ausführungsbeispiel ein zweiter MSM-Kristallkörper 130 so parallel zugeordnet, dass die Aktorbaugruppe 130 (bei geeigneter magnetischer Durchflutung) rückstellend auf eine Expansion oder Kontraktion des MSM-Kristallkörpers 128 wirken kann, bzw. umgekehrt.

Es wird somit deutlich, dass auch die Greif- bzw. Antriebs-, Halte- und Bewegungsprinzipien der Greifvorrichtung im Rahmen der vorliegenden Erfindung beliebig ausgestaltbar und nicht auf die gezeigten Ausführungsbeispiele beschränkt sind. Neben außen angreifenden Prinzipien sind so etwa auch, vgl. etwa das Ausführungsbeispiel der Fig. 5, von innen an oder in ein zu greifendes Werkstück angreifende Greifprinzipien realisierbar. Neben einstückigen, einem (üblicherweise elastische Materialdeformation vorsehenden Greiferkörpern etwa Fig. 2) können ein oder mehrere Gelenke (Fig. 1) vorgesehen sein, wobei für die Auswahl derartiger Prinzipien nicht zuletzt eine Materialauswahl eine Rolle spielt; neben den erwähnten Kunststoffkörpern, einfach etwa durch Spritzgießen oder dgl. großserientaugliche Verfahren herstellbar, bieten sich insbesondere auch metallische Greiferausgestaltungen an, wobei allen Realisierungsformen wiederum, nicht zuletzt augrund der erfindungsgemäßen Auslagerung der Magnetfelderzeugung in stationäre Bereiche außerhalb der Greifvorrichtung, gemeinsam ist, dass die eigentlich bewegte Greifvorrichtung einfach reinigbar, störungsunempfindlich und insbesondere auch für Reinraum- bzw. Hygieneerfordernisse günstig einsetzbar ist.

## Patentansprüche

1. Greifsystem mit einer entlang eines Bewegungspfades bewegbar ausgebildeten Greifvorrichtung (16; 30; 56; 90; 120) zum Fassen und Halten eines Werkstücks (70) sowie zum Bewegen des Werkstücks entlang des Bewegungspfades, und mit an einer Position des Bewegungspfades stationären und/oder unabhängig von der Greifvorrichtung bewegbar vorgesehenen Magnetfelderzeugungsmitteln (52, 80, 86, 88),
wobei die Greifvorrichtung mindestens einen, zum Herstellen einer das Fassen bzw. Halten realisierenden Wirkpaarung mit dem Werkstück relativ zu einem zweiten Kontaktabschnitt (20; 40; 68) antreibbaren ersten Kontaktabschnitt (18; 38; 66) aufweist, dem zum Ausüben einer Antriebskraft als Reaktion auf eine Magnetfeldbeaufschlagung durch die Magnetfelderzeugungsmittel zum magnetischen Zusammenwirken mit diesen eingerichtete Aktormittel (22; 44; 54; 128) zugeordnet sind,
**dadurch gekennzeichnet, dass** die Aktormittel aus einem magnetischen Formgedächtnislegierungsmaterial sind.

2. System nach Anspruch 1,
**dadurch gekennzeichnet,**
**dass** der mindestens eine erste und der mindestens eine zweite Kontaktabschnitt einen zum bevorzugt zangenartigen Zusammenwirken mit dem Werkstück ausgebildeten Greifer realisieren, wobei der erste bzw. der zweite Kontaktabschnitt an Greifbacken oder Greifarmen (12; 14; 34; 36; 62; 64) des Greifers ausgebildet ist.

3. System nach Anspruch 2,
**dadurch gekennzeichnet,**
**dass** der Greifer ein Rotieren, Tordieren, Deformieren, Verschwenken und/oder Relativverschieben von den ersten und/oder den zweiten Kontaktabschnitt realisierenden Körperabschnitten eines ein- oder mehrteilig realisierten Greiferkörpers als Reaktion auf die Antriebskraft der Aktormittel vorsieht.

4. System nach Anspruch 2 oder 3,
**dadurch gekennzeichnet,**
**dass** der Greifer zumindest abschnittsweise aus einem Kunststoffund/oder Metallmaterial ausgebildet ist, an welchem die Aktormittel ansitzen oder in welchen die Aktormittel bevorzugt unlösbar integriert sind.

5. System nach einem der Ansprüche 1 bis 4,
**dadurch gekennzeichnet,**
**dass** die Wirkpaarung ein Klemmen, Eingreifen, Mitnehmen, Verriegeln und/oder Reiben, insbesondere Haftreiben, des ersten und/oder zweiten Kontaktabschnitts am Werkstück realisiert.

6. System nach einem der Ansprüche 1 bis 5,
**dadurch gekennzeichnet,**
**dass** die insbesondere entlang einer Expansionsrichtung langgestreckt ausgebildeten Aktormittel als Reaktion auf die Magnetfeldbeaufschlagung in der Expansionsrichtung expandierbar und/oder komprimierbar ausgebildet und eingerichtet sind.

7. System nach einem der Ansprüche 1 bis 6,
**dadurch gekennzeichnet,**
**dass** die Aktormittel zum Zusammenwirken mit Rückstell- und/oder Federmitteln (26; 130) so ausgebildet und eingerichtet sind, dass eine Rückstell- bzw. Federkraft der Rückstell- und/oder Federmittel in einem nicht von einem Magnetfeld beaufschlagten Betriebszustand der Aktormittel das Fassen und Halten bewirken oder unterstützen kann.

8. System nach Anspruch 7,
**dadurch gekennzeichnet,**
**dass** die Rückstell- bzw. Federmittel so ausgebildet und zum Zusammenwirken mit den Aktormitteln eingerichtet sind, dass in dem nicht beaufschlagten Betriebszustand die Rückstell- bzw. Federkraft ein Zurückführen der Aktormittel in eine Ausgangsstellung des magnetisches Formgedächtnislegierungsmaterials bewirken.

9. System nach Anspruch 7,
**dadurch gekennzeichnet,**
**dass** die Rückstell- bzw. Federmittel so ausgebildet und zum Zusammenwirken mit den Aktormitteln eingerichtet sind, dass die Aktormittel in einer durch die Magnetfeldbeaufschlagung erreichten Stellung auch in dem nicht beaufschlagten Betriebszustand verbleiben und eine zusätzliche Magnetfeldbeaufschlagung, bevorzugt mit einem Magnetfeld mit einer abweichenden Magnetfeldrichtung, ein Zurückführen der Aktormittel in eine Ausgangsstellung vor der Magnetfeldbeaufschlagung bewirkt.

10. System nach einem der Ansprüche 1 bis 9,
**dadurch gekennzeichnet,**
**dass** die stationär an einer ersten Position des Bewegungspfades vorgesehenen Magnetfelderzeugungsmittel so ausgebildet und angeordnet sind, dass ein den ersten und den zweiten Kontaktabschnitt realisierender, die Aktormittel aufweisender und entlang des Bewegungspfades bewegbarer Greifer nur an der ersten Position das magnetische Zusammenwirken ermöglicht, wobei bevorzugt am Greifer keine Magnetfelder erzeugenden Mittel mechanisch verbunden vorgesehen sind.

11. System nach Anspruch 10, **gekennzeichnet durch** an einer von der ersten Position beabstandeten zweiten Position des Bewegungspfades vorgesehene, weitere Magnetfelderzeugungsmittel (80), die so zum magnetischen Zusammenwirken mit den Aktormitteln ausgebildet und eingerichtet sind, dass an der zweiten Position ein mechanischer Handhabungsvorgang des Werkstücks, insbesondere ein Lösen vom ersten und/oder zweiten Kontaktabschnitt, bewirkt werden kann.

12. System nach einem der Ansprüche 1 bis 11,
**dadurch gekennzeichnet,**
**dass** die Magnetfelderzeugungsmittel einen Permanentmagneten und/oder einen elektrisch ansteuerbare Spulenmittel aufweisenden Elektromagneten aufweisen.

13. System nach Anspruch 12,
**dadurch gekennzeichnet,**
**dass** die Spulenmittel des Elektromagneten so beschaltet und/oder angesteuert ausgebildet sind, dass diese temporär bestrombar, insbesondere nur zu einer Zeit bestromt sind, zu der sich die Aktormittel an einer zum magnetischen Zusammenwirken mit den Magnetfelderzeugungsmitteln vorgesehenen Position oder an einer dieser Position benachbarten Position befinden.

14. Verwendung des Greifsystems nach einem der Ansprüche 1 bis 13 in der industriellen Fertigungs- und/oder Fördertechnik.

## Claims

1. A gripper system having a gripper device (16; 30; 56; 90; 120) designed so as to be movable along a movement path and serving for gripping and holding a workpiece (70) and for moving the workpiece along the movement path, and having magnetic field generating means (52, 80, 86, 88) being static at one position of the movement path and/or provided so as to be movable independently of the gripper device,
wherein the gripper device has at least one first contact section (18; 38; 66) which can be driven relative to a second contact section (20; 40; 68) to produce an operative pairing with the workpiece that effects the gripping or holding action, which first contact section is assigned actuator means (22; 44; 54; 128) which are designed to magnetically interact with the magnetic field generating means so that they exert a drive force in reaction to an application of a magnetic field by the magnetic field generating means,
**characterized in that**
the actuator means are made of a magnetic shape-memory alloy material.

2. The system according to claim 1,
**characterized in that**
the at least one first and the at least one second contact section implement a gripper designed for purposes of a, preferably tong-like, interaction with the workpiece, wherein the first and the second contact section are realized on gripping jaws or gripping arms (12; 14; 34; 36; 62; 64) of the gripper.

3. The system according to claim 2,
**characterized in that**
the gripper provides for the rotation, twisting, deformation, pivoting and/or relative displacement of member sections realizing the first and/or second contact section of a gripper member realized in one or several parts in reaction to the drive force of the actuator means.

4. The system according to claim 2 or 3,
**characterized in that**
the gripper is at least sectionwise made of a plastic and/or metal material on which the actuator means are seated or in which the actuator means are, preferably indissolubly, integrated.

5. The system according to any one of claims 1 to 4,
**characterized in that**
the operative pairing of the first and/or second contact section on the workpiece realizes a clamping action, an engagement action, an accompanying action, a locking action, and/or a frictional action, in particular a static frictional action.

6. The system according to any one of claims 1 to 5,
**characterized in that**
the actuator means realized in an elongated manner, in particular along an expansion direction, are designed and set up such that they can be expanded and/or compressed in the expansion direction in reaction to the application of the magnetic field.

7. The system according to any one of claims 1 to 6,
**characterized in that**
the actuator means are designed and set up for purposes of interaction with reset means and/or spring means (26; 130), such that a reset force or spring force of the reset and/or spring means can effect or promote the gripping and holding action in an operating state of the actuator means in which no magnetic field is applied.

8. The system according to claim 7,
**characterized in that**
the reset or spring means are designed and set up for purposes of interaction with the actuator means, such that the reset or spring force effects a return of the actuator means into an initial position of the magnetic shape-memory alloy material in the operating state in which no magnetic field is applied.

9. The system according to claim 7,
**characterized in that**
the reset means or spring means are designed and set up for purposes of interaction with the actuator means, such that the actuator means remain in a position achieved by the application of the magnetic field, even in the operating state in which no magnetic field is applied, and an additional application of a magnetic field, preferably of a magnetic field which has a different magnetic field direction, effects a return of the actuator means into an initial position before the application of a magnetic field.

10. The system according to any one of claims 1 to 9,
**characterized in that**
the magnetic field generating means provided in a static manner at a first position of the movement path are designed and disposed such that a gripper realizing the first and the second contact section, having the actuator means and being movable along the movement path only enables the magnetic interaction at the first position, preferably no mechanically connected magnetic field generating means being provided at the gripper.

11. The system according to claim 10, **characterized by** additional magnetic field generating means (80) provided at a second position of the movement path that is spaced apart from the first position, the additional magnetic field generating means being designed and set up for purposes of magnetic interaction with the actuator means, such that, at the second position, a mechanical process of manipulation of the workpiece, in particular a removal from the first and/or second contact section, can be effected.

12. The system according to any one of claims 1 to 11,
**characterized in that**
the magnetic field generating means have a permanent magnet and/or an electromagnet which has coil means that can be electrically activated.

13. The system according to claim 12,
**characterized in that**
the coil means of the electromagnet are connected and/or activated such that they can be energized temporarily, in particular only at a time at which the actuator means are located at a position provided for magnetic interaction with the magnetic field generating means or at a position adjacent to this position.

14. A use of the gripper system according to any one of claims 1 to 13 in the industrial production and/or conveyor technology.

## Revendications

1. Système de préhension comprenant un dispositif de préhension (16 ; 30 ; 56 ; 90 ; 120) réalisé de manière à être déplaçable le long d'un trajet de déplacement et destiné à saisir et tenir une pièce (70) et à déplacer la pièce le long du trajet de déplacement, et comprenant des moyens de génération de champ magnétique (52, 80, 86, 88) stationnaires à une position du trajet de déplacement et/ou prévus de manière à être déplaçables indépendamment du dispositif de préhension,
le dispositif de préhension ayant au moins une première partie de contact (18 ; 38 ; 66) qui peut être entraînée par rapport à une deuxième partie de contact (20 ; 40 ; 68) afin de réaliser un accouplement actif avec la pièce qui réalise le processus de saisie ou de maintien, des moyens d'actionneur (22 ; 44 ; 54 ; 128) étant assignés à la première partie de contact, les moyens d'actionneur étant adaptés pour interagir de manière magnétique avec les moyens de génération de champ magnétique afin d'exercer une force d'entraînement en réponse à l'application d'un champ magnétique par les moyens de génération de champ magnétique,
**caractérisé en ce que**
les moyens d'actionneur sont en matière d'alliage à mémoire de forme magnétique.

2. Système selon la revendication 1,
**caractérisé en ce que**
l'au moins une première partie de contact et l'au moins une deuxième partie de contact réalisent un préhenseur qui est destiné à interagir avec la pièce, de préférence à la manière d'une pince, la première et la deuxième partie de contact étant réalisées à des mâchoires ou à des bras de préhension (12 ; 14 ; 34 ; 36 ; 62 ; 64) du préhenseur.

3. Système selon la revendication 2,
**caractérisé en ce que**
le préhenseur prévoit une rotation, une torsion, une déformation, un pivotement et/ou un déplacement relatif de parties de corps d'un corps de préhenseur qui réalisent la première et/ou la deuxième partie de contact, le corps de préhenseur étant réalisé en une ou plusieurs pièces, en réponse à la force d'entraînement des moyens d'actionneur.

4. Système selon la revendication 2 ou la revendication 3,
**caractérisé en ce que**
le préhenseur est réalisé au moins par sections en matière plastique et/ou métallique, les moyens d'actionneur étant fixés à ou étant intégrés, de préférence de manière inséparable, dans la matière plastique et/ou métallique.

5. Système selon l'une quelconque des revendications 1 à 4,
**caractérisé en ce que**
l'accouplement actif réalise un serrage, un engagement, un déplacement, un verrouillage et/ou un frottement, notamment un frottement statique, de la première et/ou la deuxième partie de contact sur la pièce.

6. Système selon l'une quelconque des revendications 1 à 5,
**caractérisé en ce que**
les moyens d'actionneur qui ont une forme allongée, notamment le long d'une direction d'expansion, sont réalisés et configurés de manière à être expansible et/ou compressible dans la direction d'expansion en réponse à l'application de champ magnétique.

7. Système selon l'une quelconque des revendications 1 à 6,
**caractérisé en ce que**
les moyens d'actionneur sont réalisés et configurés afin d'interagir avec des moyens de rappel et/ou de ressort (26 ; 130) de telle manière qu'une force de rappel ou de ressort des moyens de rappel et/ou de ressort peut entraîner ou supporter le processus de saisie et le processus de maintien dans un état de fonctionnement des moyens d'actionneur dans lequel aucun champ magnétique est appliqué.

8. Système selon la revendication 7,
**caractérisé en ce que**
les moyens de rappel ou de ressort sont réalisés et configurés afin d'interagir avec les moyens d'actionneur de telle manière que la force de rappel ou de ressort entraîne un retour des moyens d'actionneur à une position de départ de la matière d'alliage à mémoire de forme magnétique dans l'état de fonctionnement dans lequel aucun champ magnétique est appliqué.

9. Système selon la revendication 7,
**caractérisé en ce que**
les moyens de rappel ou de ressort sont réalisés et configurés afin d'interagir avec les moyens d'actionneur de telle manière que les moyens d'actionneur restent dans une position atteinte par l'application de champ magnétique dans un état de fonctionnement dans lequel aucun champ magnétique est appliqué et qu'une application de champ magnétique additionnelle, de préférence d'un champ magnétique qui a une direction de champ magnétique différente, entraîne un retour des moyens d'actionneur à une position de départ avant l'application de champ magnétique.

10. Système selon l'une quelconque des revendications 1 à 9,
**caractérisé en ce que**
les moyens de génération de champ magnétique prévus de manière stationnaire à une première position du trajet de déplacement sont réalisés et disposés de telle manière qu'un préhenseur réalisant la première et la deuxième partie de contact, ayant les moyens d'actionneur et déplaçable le long du trajet de déplacement permet l'interaction magnétique seulement à la première position, de préférence aucun moyen de génération de champ magnétique relié de manière mécanique étant prévu sur le préhenseur.

11. Système selon la revendication 10, **caractérisé par** des moyens de génération de champ magnétique additionnels (80) prévus à une deuxième position du trajet de déplacement qui est espacée de la première position, les moyens de génération de champ magnétique additionnels étant réalisés et configurés afin d'interagir de manière magnétique avec les moyens d'actionneur de telle manière qu'une opération de manipulation mécanique de la pièce, notamment un détachement de la première et/ou la deuxième partie de contact, peut être entraînée à la deuxième position.

12. Système selon l'une quelconque des revendications 1 à 11,
**caractérisé en ce que**
les moyens de génération de champ magnétique ont un aimant permanent et/ou un électroaimant qui a des moyens de bobine qui peuvent être commandés de manière électrique.

13. Système selon la revendication 12,
**caractérisé en ce que**
les moyens de bobine de l'électroaimant sont reliés et/ou commandés de telle manière qu'ils peuvent être alimentés en courant temporairement, notamment seulement à un moment où les moyens d'actionneur sont à une position prévue pour l'interaction magnétique avec les moyens de génération de champ magnétique ou à une position qui est adjacente à ladite position.

14. Utilisation du système de préhension selon l'une quelconque des revendications 1 à 13 dans la technologie de fabrication et/ou de manutention industrielle.
